# EUROPEAN PATENT SPECIFICATION

(11) **EP 1 995 602 B1**
(45) Date of publication and mention of the grant of the patent: **14.08.2013**
(21) Application number: 07108729.0
(22) Date of filing: 23.05.2007
(51) Int. Cl.: G01R 31/28

(54) **Probe board, test fixture, method for making a probe board, and method for testing a printed circuit board**
Sondenkarte, Testvorrichtung, Verfahren zur Herstellung einer Sondenkarte und Verfahren zum Testen einer Leiterplatte
Panneau de sonde, élément de test, procédé de fabrication d'un panneau de sonde, et procédé de test pour une carte de circuit imprimé

(43) Date of publication of application: 26.11.2008
(73) Proprietor: RRo Holding B.V., 3016 AJ Rotterdam (NL)
(72) Inventor: Roelvink, Hendrik Gerard, 3016 AJ, Rotterdam (NL)
(74) Representative: Jansen, Cornelis Marinus

(56) References cited:
- EP-A- 0 372 666
- FR-A- 2 224 972
- FR-A- 2 608 775
- US-A- 5 572 144
- US-A1- 2004 178 815

## Description

The invention relates to a probe board for testing a target PCB (Printed Circuit Board), preferably to be used in a test fixture, provided with probes for contacting target points on a target PCB.

The invention also relates to a test fixture, comprising a target PCB holding frame, a probe board holding frame and guides for guiding at least one of the two frames at least in a direction perpendicular to said frames, wherein the probe board holding frame is arranged to allow connection between probes on a probe board and a user interface circuit.

The invention also relates to a method for making a probe board, wherein a printed circuit pattern is designed, wherein said pattern is used for configuring target points on a target PCB.

Furthermore, the invention relates to a method for testing a Printed Circuit Board.

For testing PCB's (printed circuit boards) test fixtures are used that connect target points on a target PCB (Printed Circuit Board) to automatic test equipment. These target points are certain contact locations on the prototype PCB that need to be tested before the PCB is produced. These target points may be tested before, during and/or after the PCB is assembled with electrical components.

A conventional test fixture is equipped with spring-loaded probes fixed to a probe board. When testing, the probe board is moved towards the target PCB such that the probes are pressed against target points on the target PCB, wherein a reliable contact has to be made between several, tens, hundreds or thousands of probes and target points.

The probe board is guided along precisely calibrated guiding means and pressed down by vacuum or mechanic means in the test fixture, while the probe board is kept in place. Each test probe is connected to test equipment through interface pins and fixture wiring. During a test, signals are fed through the contact points and processed by the test equipment, whereafter the results are displayed on a user interface for evaluation by an expert.

For testing the PCB, multiple experts in different fields are involved. For start an electro technical design engineer designs a target PCB, for example. The engineer indicates the target points in a drawing and the drawing is sent to a PCB manufacturer. Prototypes of the PCB that is not yet assembled with the electrical components are developed by a PCB manufacturer, and may for example sent to an equipper, along with a specification of the electrical components. The equipper assembles the electrical components to the PCB such that a prototype of a PCB assembly is obtained that can be put under test, for which the final prototypes are sent to the test site. The test fixture and automatic test equipment comprise advanced precision equipment and are usually situated at the PCB manufacturer.

Known test fixtures are usually fairly complex and relatively expensive. Expert operators and special equipment is needed to operate the test fixture. Besides, before the PCB is tested and can be implemented the preassembled PCB is sent between different expert parties, leading to time and money consuming development cost.

It is noted that French patent publication FR 2608775 discloses a test fixture for testing a target PCB wherein a probe board includes a via for contacting a target point on the target PCB. US patent 5,572,144 discloses a test fixture wherein the target board is statically held against a nest plate, which is statically affixed to a main frame. A bottom frame has statically attached thereto a bottom bed of nails, whose probes can protrude through nest plate openings corresponding to targets on the target board. The probes are brought into contact with the targets by vertically moving the bottom frame toward the target board held against the nest plate.

A goal of the invention can be to provide for time and cost efficient test equipment for PCB.

Another goal of the invention can be to provide in user friendly test equipment for PCB.

At least one of these goals and/or other goals may be achieved by a probe board for testing a target PCB (Printed Circuit Board) according to claim 1.

A target PCB can be understood as a printed circuit board prototype of which certain contact locations, i.e. target points, need to be tested. The target PCB may be a PCB prototype before, during or after it is assembled with electrical components. The probe board PCB can be understood as a PCB that carries the probes that connect the target points to the test equipment. It is found that by constructing a probe board using a PCB, the probe board can be made relatively easily, since PCB's are readily available in the field. Preferably, the probe board PCB can be made from the same PCB material as the target PCB and/or comprises a standard PCB.

An electrical circuit of the PCB can be made on the PCB in a known way, e.g. by etching, to which the probes can be connected, also in a known way, e.g. by soldering. In this way, the probe board PCB according to the invention can be constructed relatively quickly as compared to known probe boards and therefore the fixed costs for setting up the probe board may be lower as compared to known probe boards and test fixtures. Since the probe board according to the invention is cost and time efficient to make, and multiple users can set up a corresponding test fixture relatively easily, the test fixture according to the invention can be installed at in principle any location to test a PCB, e.g. before, during and/or after assembly. For example, also equippers of electrical components can test PCB's that are assembled by them, whereas with known test fixtures the fixed starting costs would be too high for the equipper.

Advantageously, the drawings for the target PCB can be used to draw the probe board. For example, in the drawing the indicated target points are replaced by probe points, where the probes will be connected to the PCB. With simple or no modifications in the drawing, the PCB manufacturer can provide for a probe board as well as a target PCB, since in principle all the material and knowledge is at hand.

At least one of abovementioned goals and/or other goals may also be achieved by a test fixture according to claim 6.

With such a test fixture a target PCB can be tested by using PCB's. By guiding the probe board PCB to the target PCB a connection can be established between the probes and target points on the target PCB. The probes may be connected to, on the one hand, target points on the target PCB, and, on the other hand, a user interface circuit such as an I/O interface and/or computer screen. With the invention, a target PCB and a probe board PCB can be ordered by e.g. a manufacturer, designer or equipper, and tested by that manufacturer or designer in one time, instead of ordering a target PCB and then sending the target PCB to a specialist having the specialized testing equipment. Advantageously, the PCB's can be placed in the respective holding frames and testing can be performed.

Furthermore at least one of abovementioned goals and/or other goals may be achieved by a method for making a probe board according to claim 19.

At least one of abovementioned goals and/or other goals may also be achieved by a method for testing a Printed Circuit Board (PCB) according to claim 23.

In clarification of the invention, these and further embodiments of the invention, and advantages thereof will be further elucidated with reference to the drawing. In the drawing:
figure 1 is a schematic front sectional view of a test fixture;
figure 1A is a top view of a probe board PCB;
figure 1B is a detail of figure 1A;
figure 2 is a schematic front sectional view of holding frames in a test fixture holding PCB's;
figure 2A is a sectional front view of a part of holding frames with PCB's and a clamping element;
figure 2B is a perspective view of two PCB holding frames;
figure 3 is a perspective view of a test fixture;
figure 4 is a perspective view of a test fixture;
figure 4A is a perspective view of a test fixture;
figure 4B is a perspective view of a holding element for a probe board PCB holding frame;
figure 5 is a perspective view of a test fixture;
figure 6A, 6B and 6C are perspective views of a test fixture, each showing a different position of the grip;
figure 6D, 6E and 6F show detailed views of the test fixture, in particular of the handle;
figure 7 is a perspective view of a test fixture;
figure 7A is a perspective view of a test fixture;
figure 7B is a detailed view of the test fixture, in particular of a clamping element;
figure 7C is a detailed sectional view of the test fixture, in particular of the clamping element;
figure 8 is a perspective view of a target PCB holding frame.

In this description, identical or corresponding parts have identical or corresponding reference numerals. The exemplary embodiments shown should not be construed to be limitative in any manner and serve merely as illustration.

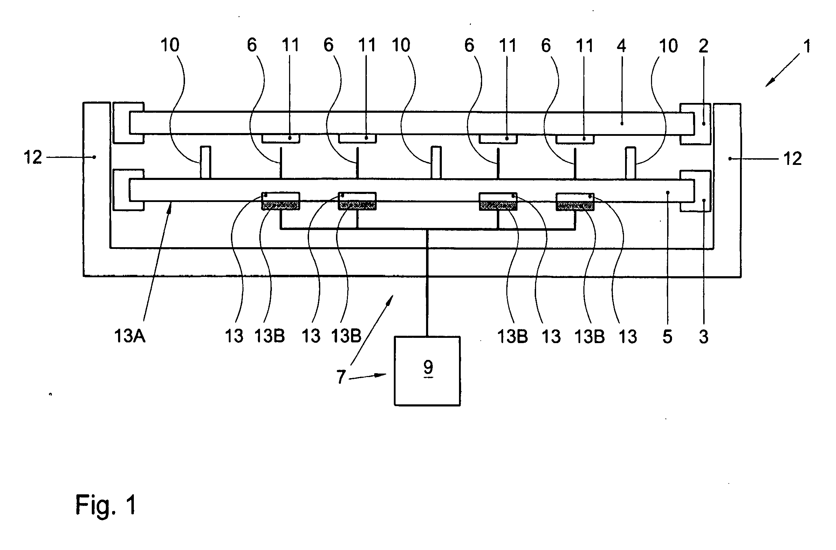

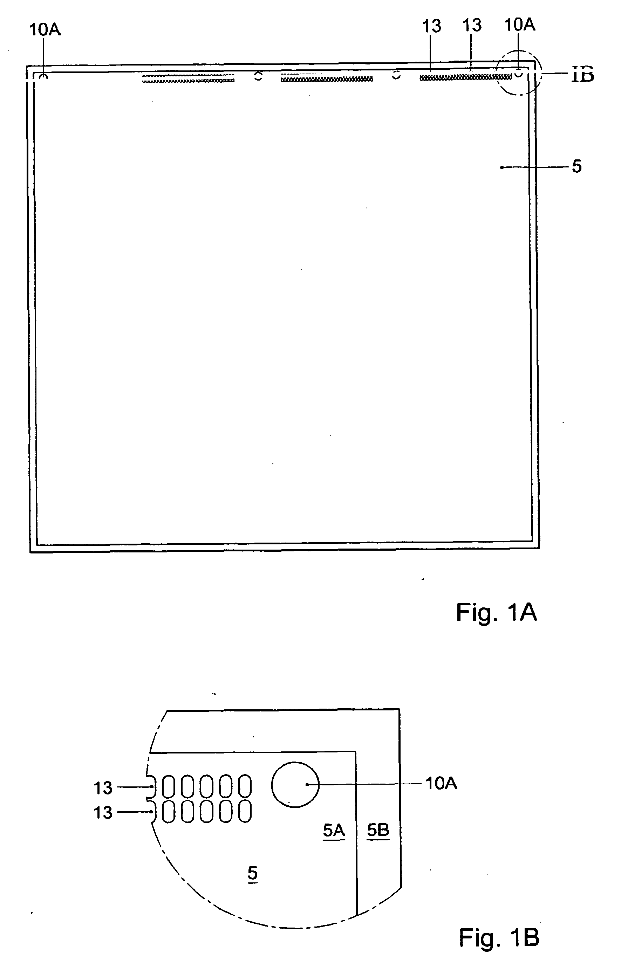

Figure 1 shows test fixture 1, comprising a target PCB holding frame 2, holding a target PCB 4 and a probe board holding frame 3 holding a probe board PCB 5. The respective holding frames 2, 3 are arranged to hold the respective PCB's 4, 5 near their sides, i.e. edges, directly or indirectly. The probe board holding frame 3 is arranged to allow connection between probes 6 on the probe board PCB 5 and a user interface circuit 7, the latter comprising an I/O interface 8 and a computer screen 9. The user interface circuit 7 can be integrally provided in the test fixture 1 beforehand or can be separately connected to the frame of the test fixture 1, forming a separate part of the total test equipment.

The probes 6 are configured for contacting target points 11 on the target PCB 4 and are positioned on the probe board PCB 5. Advantageously, the probes 6 may comprise resilient contact pins, resiliently provided in probe busses, which principle is known in the art. The probes 6 provide for electrical contact between the target points 11 and the I/O interface 8 via a probe board PCB circuit 13A which is provided in the probe board PCB 5. To make a reliable contact, the target points 11 have approximately the same relative position on the target PCB 4 as the probes 6 on the probe board PCB 5. The probe board PCB circuit 13A on the probe board PCB 5 connects the probes 6 to connecting points 13B that are provided in the probe board PCB holding frame 3. For connection to the connection points 13B, the probe board PCB circuit 13A is provided with connector plates 13 that are positioned such that, in use, they connect readily to the connector points 13B of the probe board PCB holding frame 3. In alternative embodiments, wires and/or alternative circuits may be provided to connect the probes 6 to the user interface circuit 7.

Figure 1 also shows positioning pins 10, for mating with positioning holes in the target PCB 4, and guides 12 for guiding the probe board holding frame 3. The positioning pins 10, positioning holes and/or the guides 12 may be provided to aid in positioning the probes 6 for a reliable contact with the target points 11. Also, positioning pins 10 on the probe board 5 may prevent curving of the target PCB 4, for example when the target PCB 4 has a relatively large surface and/or is relatively thin, by pressing against the target PCB 4. The holding frames 2, 3 of the test fixture 1 may be driven along the guides 12 by a manual drive and/or an electromotor, for example, in a direction towards or away from the target PCB holding frame 2.

Advantageously, the target PCB holding frame 2 holds the target PCB 4 at the sides thereof and/or the target PCB holding frame 2 is arranged above probe board holding frame 3. By holding the target PCB 4 at the sides, the electrical components that are provided on the opposite side of the target points 11 can be visually checked, for example after equipping the target PCB 4 with electrical components.

The probe board PCB 5 is commonly available standard PCB material and can be of any dimension. Advantageously, the probe board PCB 5 may be at least of the same material as the target PCB 4, such that both PCB's 4, 5 can be patterned in a substantially uniform manner and/or by the same person. Examples of the respective PCB materials that may be used are FR-4, FR-2, polyamide, GETEK, BT-epoxy, cyanate ester and PTFE, preferably FR-4 or FR-2. The dimensions of the respective PCB's may vary substantially. Examples of surface dimensions of probe board PCB's 5 are 420 mm by 420 mm, 400 x 400 mm, 380 x 380 mm, having thicknesses of 3,2; 2,4; 1,6 or 1,55 mm, approximately. Obviously, the target PCB 4 may have any size for example having surface dimensions of 380 x 380 mm or less. The probe board holding frame 3 can be configured to hold one or more PCB's of standard thicknesses. Obviously, the invention should not be limited to the particular sizes of the PCB's that are mentioned in this description.

The patterned circuit 13A, with connector plates 13, can be readily provided on the probe board PCB 5, preferably in a way that is common practice in the art of PCB's. For example the probes 6 and/or connector plates 13 may be soldered on the probe board PCB 5 and/or with so-called through hole techniques. Figure 1A and 1B show a probe board PCB 5 for use in a test fixture 1, and a detailed view of a corner of the probe board PCB 5, respectively. The probe board PCB 5 is provided with connector plates 13 near a side thereof, such that these plates 13 may readily connect to connector points 13B that are provided in the PCB holding frame 3. Preferably the probe board PCB 5 is provided with a solder mask 5A and has a free zone 5B that is free of of the solder mask 5A near the sides. The free zone 5B is convenient for having the probe board PCB 5 abutted near the sides by the probe board PCB holding frame 3. In the shown embodiment, positioning holes 10A are provided in the probe board PCB 5, that mate with positioning projections of the probe board PCB holding frame 3. Like the connector plates 13, these holes 10A may be conveniently arranged near the sides of the probe board PCB 5. The elements 5A, 5B, 6, 10 and circuits 13, 13A that are provided on the PCB 5 can be readily provided in a way that is common practice for an equipper, circuit designer and/or PCB manufacturer, such that in principle any skilled person can making a probe board PCB 5 according to the invention, preferably for use in a test fixture 1 according to the invention.

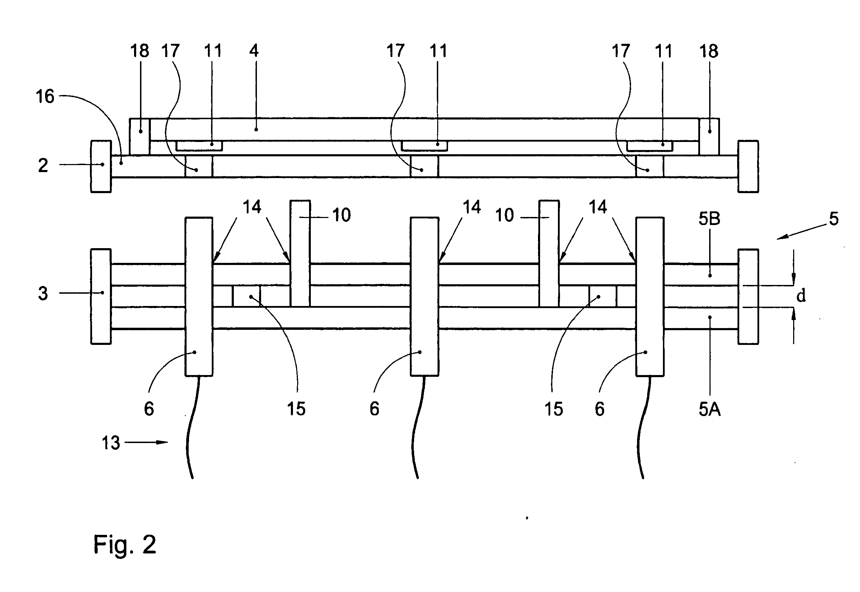

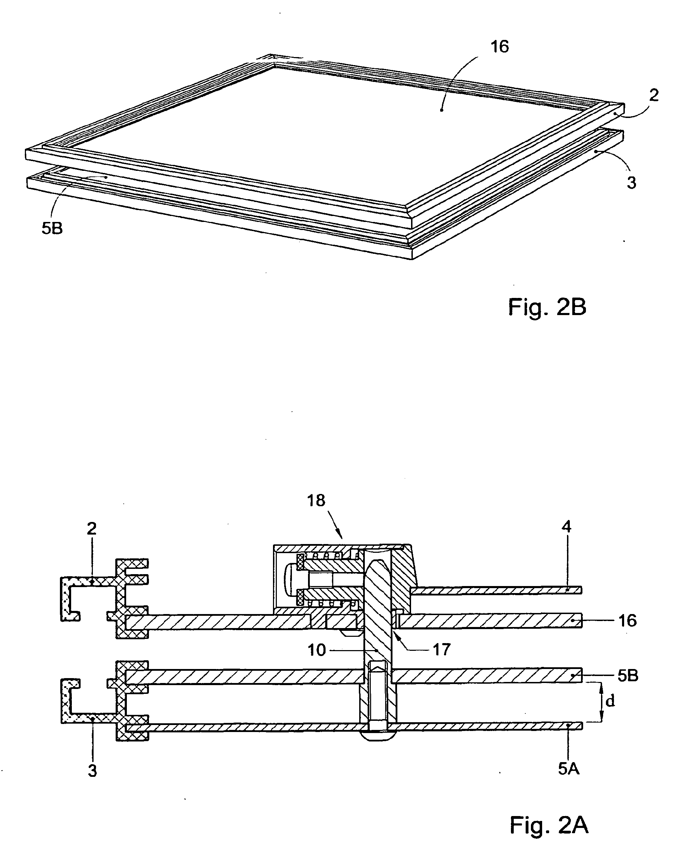

In a preferred embodiment, the probe board PCB 5 comprises multiple probe board PCB's 5A, 5B, as can be seen from figure 2. According to the invention the probe board comprises two PCB's 5A, 5B extending parallel to each other. Conveniently, the probe board holding frame 3 may be arranged to hold at least two PCB's substantially parallel to each other. The probes 6 are connected to a first probe board PCB 5A. The probes 6 and/or the positioning pins 10 extend through holes 14 in the second probe board PCB 5B, the second probe board PCB 5B serving as to stiffen the PCB probe board 5 and to keep the probes 6 approximately at a desired, preferably a right angle to the target PCB 4 and/or the first probe board PCB 5A. The two probe board PCB's 5A, 5B may be positioned at a distance d of at least 3 mm from each other, preferably at least 8 mm, more preferably approximately 10 mm, for example, so that a stiffened probe board PCB 5 is obtained, e.g. with the aid of the probes 6 and positioning pins 10 that extend between the two probe board PCB's 5A, 5B. To set a distance d between the PCB's 5A, 5B the first and/or second probe board PCB 5A, 5B can be provided with spacers 15, and/or the probe board holding frame 3 can be arranged to hold the boards 5A, 5B at a distance d. The latter is illustrated in figure 2A.

In an embodiment the holding frames 2, 3, 3B comprise a metal, preferably aluminium profile, abutting the respective PCB 4, 16, 5, 5C near the sides (see figure 2A, for example). The probe board PCB holding frames 3, 3B and the target PCB holding frame 2 may have the same dimensions and may be arranged around at least three, preferably around all four edges of the respective PCB 4, 5, 5A, 5B, 16 (see figure 2B, for example).

As can be seen from the embodiment of figure 2, the target PCB 4 is provided on a positioning PCB 16, which extends approximately parallel to the target PCB 4. The positioning PCB 16 is placed in the target PCB holding frame 2 to hold the target PCB 4. The target PCB holding frame 2 may in principle be arranged with the same features and/or advantages as the probe board holding frame 3, which is also clearly illustrated in figure 2A.

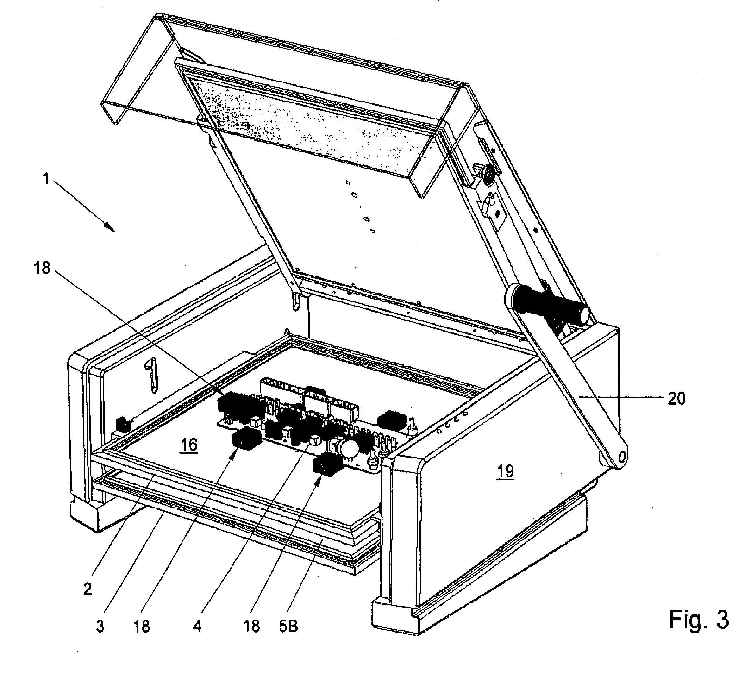

Preferably, the positioning PCB 16 is equipped with clamping elements 18 to clamp the target PCB 4 at the sides, as can be seen in figure 2A and 3. In this way the electrical components on the top of the target PCB 4 can be visually verified.

In an embodiment (not shown) the target PCB holding frame 2 may be provided with stiffening profiles to prevent bending of the positioning PCB 16. These profiles can for example be arranged across the surface of the positioning PCB 16 behind the clamping elements 18. It is advantageous when the stiffening profiles are connected to the clamping elements 18.

As can be seen from figure 2 and 2A the positioning PCB 16 has guiding holes 17 for guiding the probes 6 in line with the target points 11. The positioning PCB 16 provides for a reliable as well as easy fixture of the target PCB 5 while it can be readily made and/or provided with holes 17, stiffening profiles and/or clamping elements 18 e.g. by common practice, starting from standard PCB material. Preferably, the positioning PCB 16 has approximately the same thickness as the second probe board PCB 5B, e.g. 3,2 or 2,4 mm. The positioning PCB 16 and/or the second probe board PCB 5B, 16 may be somewhat thicker than the target PCB 4 and/or the first probe board PCB 5A. The target PCB 4 and/or the first probe board PCB 5A may for example have a thickness of approximately 1,55 mm.

In figure 3 an embodiment of a test fixture 1 according to the invention is shown with a housing 19. Before testing, the target PCB 4 is clamped in the clamping elements 18. As can be seen from the figure, the test fixture 1 comprises a manual operating mechanism comprising a handle 20 for manually operating a moving mechanism for moving the holding frames 2, 3 along the guides 12. Preferably, the transmission of the operating mechanism is such that by applying a relatively low force, e.g. of approximately 70 N, the probes 6 apply a relatively high force to the target points 11, e.g. of approximately 1100N.

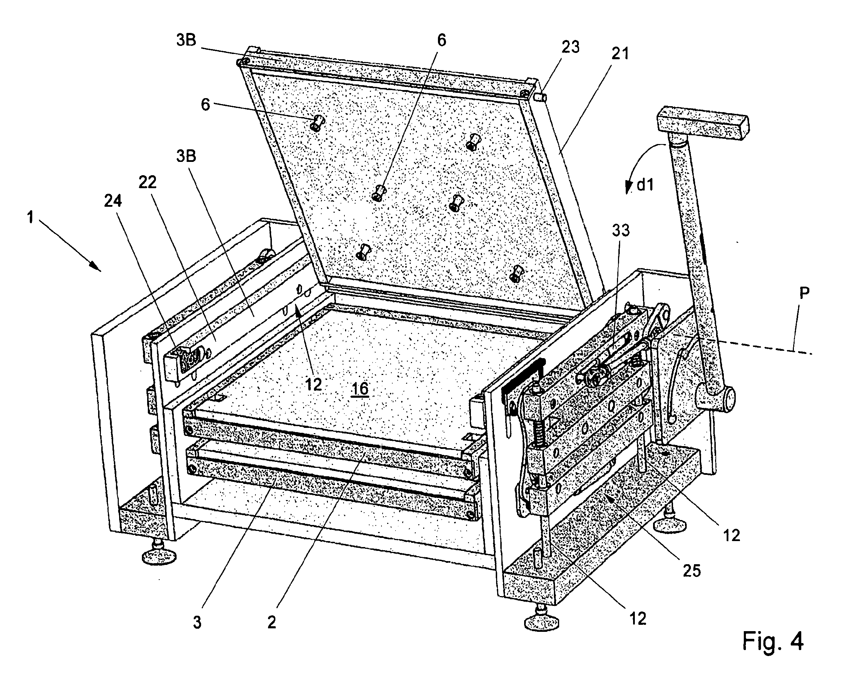

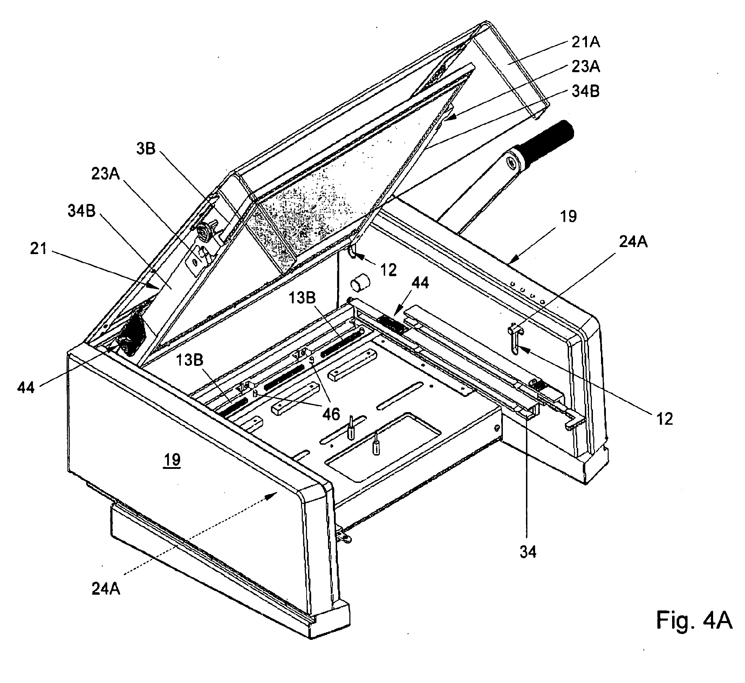

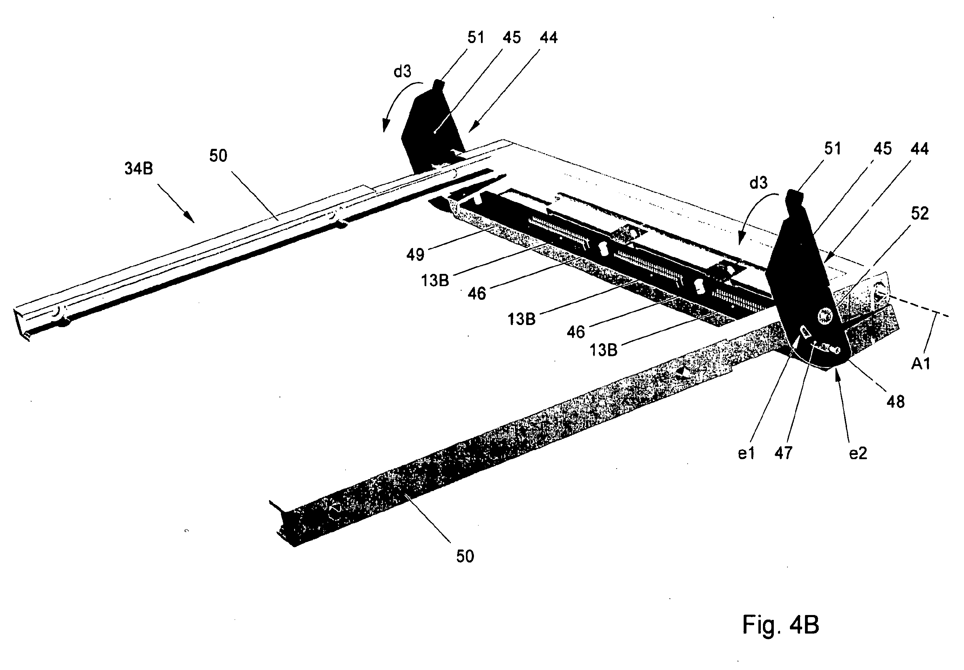

In figure 4, an embodiment is shown, wherein a part of the housing 19 is taken away. A second probe board holding frame 3B is provided for holding an upper probe board PCB 5C, which is arranged on the opposite side of the target PCB holding frame 2 with respect to the first probe board holding frame 3, i.e. above the target PCB holding frame 2. By use of the second probe board holding frame 3B, both top and bottom side of the target PCB 4 can be contacted by the probes 6 on both probe board PCB's 5, 5C held on opposite sides of the target PCB 4. In this embodiment, the target PCB 4 is not shown. The upper probe board 5C may have the same features as the probe board PCB 5 below the target PCB holding frame 2. For example, both probe boards 5, 5C may be provided with a second probe board 5B, e.g. for stiffing the probe boards 5, 5C. A positioning PCB 16 is preferably provided under the target PCB 4, although a second positioning PCB may be provided above the target PCB 4, for example for when the target PCB 4 has relatively large surface dimensions and//or has a tendency to bend.

As can be seen from figure 4, the second probe board holding frame 3B can be moved out of a parallel position, for example around a pivot axis p by means of hinges, for allowing the target PCB 4 to be placed for testing and/or removing the upper probe board PCB 5C from sight to be able to visually check the electrical components on the target PCB 4.

To facilitate hinging of the probe board holding frame 3B the test fixture 1 may comprise a hinging part 21. In an embodiment, locking parts 23, 24 can be provided on the hinging part 21 and a housing part 22, respectively, to make sure that the second probe board holding frame 3B stays in position, at least when folded down. For example, the hinging part 21 may comprise a pin 23 that pushes away a resilient finger 24 provided in the second part 22 when the hinging part 21 is closed. When the pin 23 has passed the finger 24, the pin 23 and the hinging part 21 lock in place. The hinging part 21 is locked by pushing it down, preferably by hand, such that the finger 24 and the pin interlock. Resilient means, such as a gas pressure cylinder 33, may be provided to keep and/or push the hinging part 21 open when the locking parts 23, 24 are unlocked.

Another embodiment of locking parts 23A, 24A is shown in figure 4A. Here, the hinging part 21 comprises a cover 21A and a locking part that comprises a hook 23A. The housing 19 comprises a second locking part comprising a finger 24A that abuts the hook 23A, at least in a locking position. The finger 24A may also serve to guide the second probe board PCB holding frame 3B along one of the guides 12, at least when the second probe board PCB holding frame 3B is pushed down into a locked state.

In an embodiment, first 34 and second holding elements 34B for holding the first and second probe board PCB holding frame 3, 3B, respectively, are provided such that the holding frames 3, 3B can be manually detached from and/or attached to the test fixture 1. The second probe board holding frame 5C can be disassembled from the test fixture 1 such that only the first probe board holding frame 5 is used and a better view on the topside of the target PCB 4 can be established. The holding elements 34, 34B move to and from a target PCB holding frame holding element 35, along guides 12. Advantageously, a moving frame 25 is provided to move both holding elements 34, 34B in opposite directions, to and from the target PCB holding frame holding element 35, for example by means of the handle 20 at the side of the test fixture 1.

It should be understood that, since the holding frames 2, 3, 3B can be constructed in a fixed or detachable manner to the test fixture 1, the holding elements 34, 34B, 35 could also be constructed as holding frames 2, 3, 3B that are fixed to the test fixture 1 and that could hold probe board PCB's 5, positioning PCB's 16 and/or target PCB's 4.

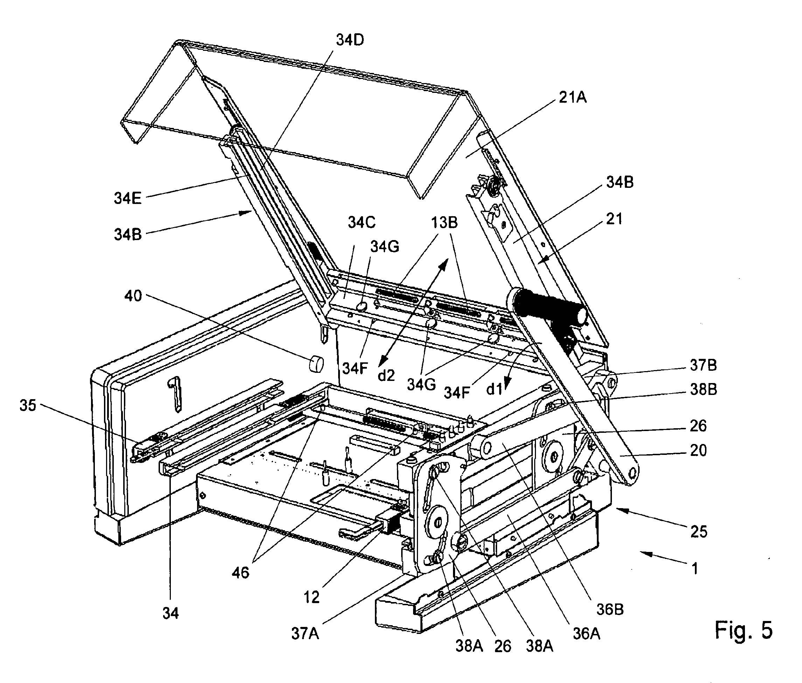

As can be seen in the embodiment of figure 5, the second holding element 34B is arranged with two subelements 34D, 34E to be able to hold the probe board PCB holding frame 3B in each subelement 34D, 34E at different heights. This can for example be advantageous when the probes 6 need to be able to contact the target PCB 4 at different heights from the target PCB 4 surface, i.e. when the target points 11 e.g. of different target PCB's 4 may be situated at different heights. The second holding element 34B is also provided with an intermediate holding element 34C that is arranged to be guided along the holding element 34B along a direction d2. This intermediate holding element 34C holds the connector points 13B so that the connector points 13B can also be slit along the holding element 34B to connect to connector plates 13 of the probe board PCB 5 that may be held at different heights, i.e. in one of the subelements 34D, 34E. Holding element guides 34F and adjusting screws 34G may be provided to guide and secure the intermediate holding element 34C to the holding element 34B.

Said moving frame 25 may comprise a parallel beam mechanism, that is actuated by the handle 20. As can be seen from figure 5, the moving frame 25 may comprise plates 26 having curved gaps. The plates 26 are connected to first beams 36A, 36B that are actuated by the handle 20. The plates 26 are also connected to second beams 37A, 37B via projections 38A, 38B that are guided through the curved gaps in the plates 26. The curved gaps drive the second beams 37A, 37B to move in opposite directions along the guides 12, at substantially equal speeds and exerting substantially equal pressure. The second beams 37A, 37B are connected to the holding elements 34, 34B, respectively, whereas the second holding element 34B is only fully connected when it is hinged down, such that it is interlocked with the finger 24A that is connected to the upper second beam 37B. In this way, the probe board PCB holding frames 3, 3B can be guided towards and from the target PCB holding frame 2, preferably such that all probes 6 apply approximately the same force to target points 11 on both sides of the target PCB 4 and contact the target points 11 at approximately the same time. Advantageously, the pressure cylinder 33, or other resilient means, is arranged in the upper second beam 37B, so that it the cover 21A may be held or pushed open also when the upper second beam 37B is moved.

In a relatively safe embodiment, before operating the test fixture 1 the cover 21A is pushed down, and/or when operating, the handle 20 is actuated by moving it in a direction dl towards the body of the user, so that the operator of the test fixture 1 doesn't have to move in the direction of the test fixture 1 when the holding frames 2, 3, 3B are closed.

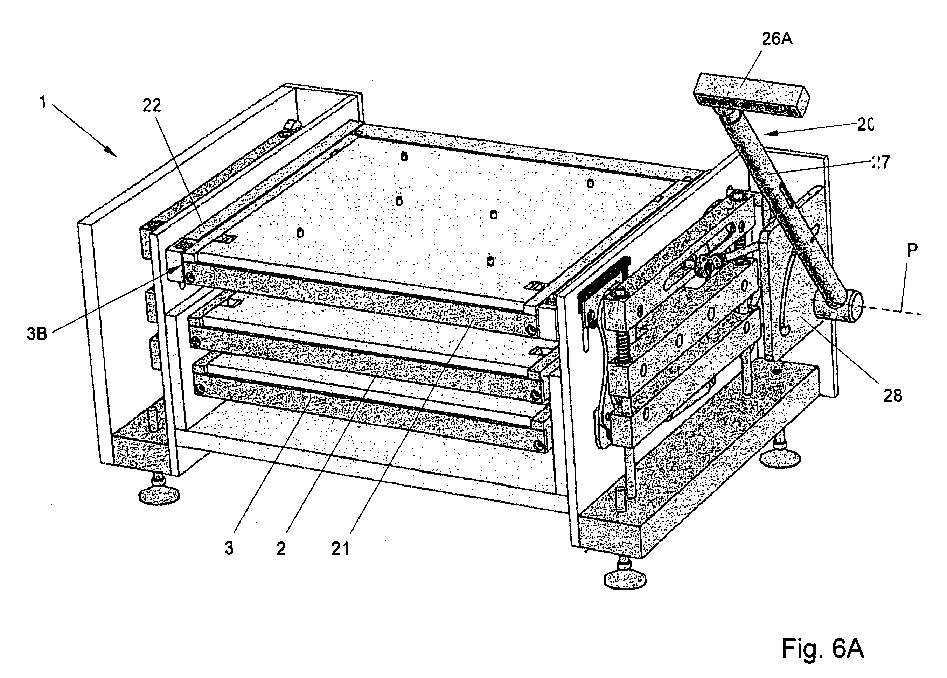

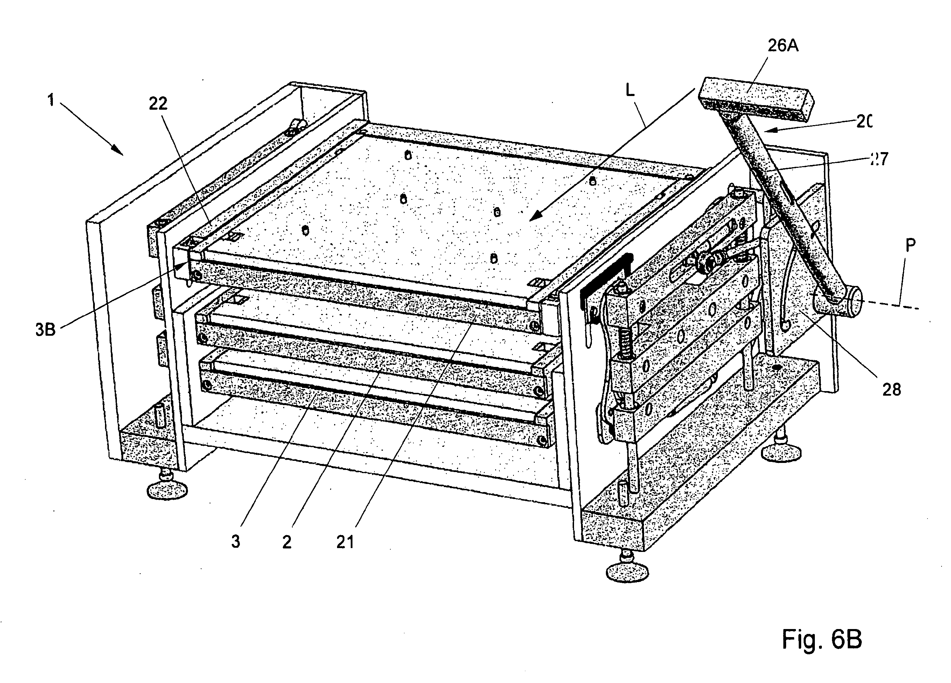

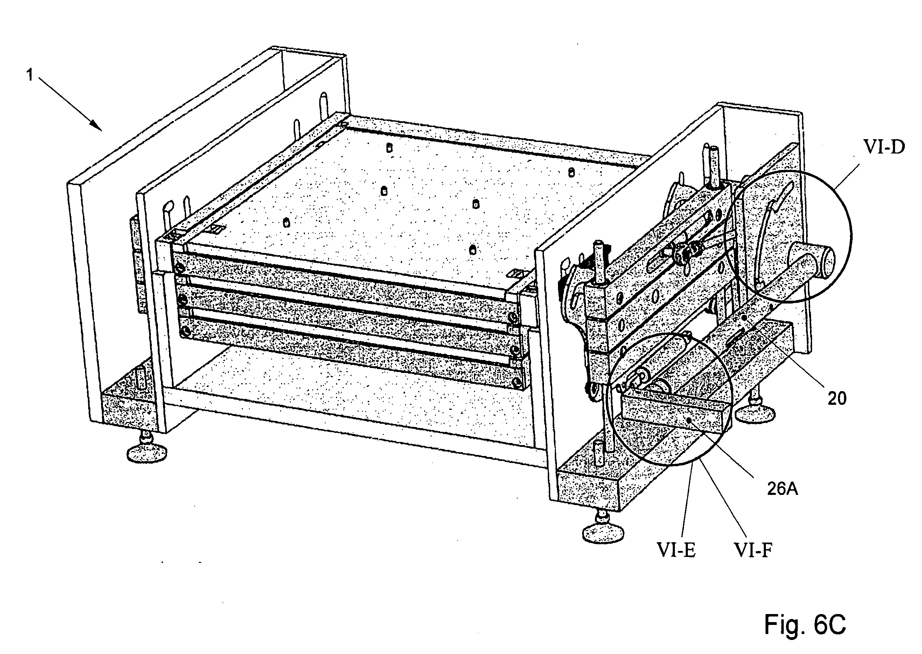

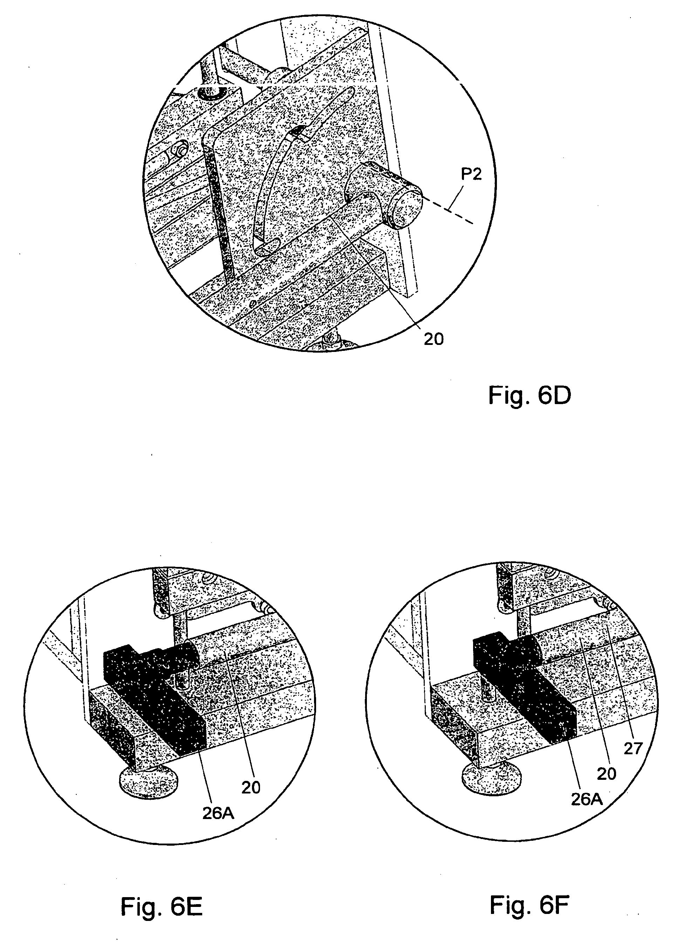

As can be seen from figures 6A, 6B, a security system can be applied to guide and lock the handle 20, providing for security measurements e.g. between folding down the hinging part 21 and moving down the second probe board holding frame 3B, and before/after placing the probes 6 to the target points 11.

As shown in figures 6A - 6E, the security system may comprise a grip 26A that may be slid along a tube 27. The handle 20 comprises a projection (not shown) that is guided by a cam 28. The grip 26A can be pulled out of the tube 27 such that it is released and can be moved along the cam 28 for a further distance. When the handle 20 is pushed down fully and the probes 6 of the probe board PBC's 5, 5C touch the target points 21, right after the probes 6 are in contact with the target points 11, the probe board holding frame 3, 3B can be secured in place by the handle 20, e.g. by sliding the grip 26A into the tube 27 (figure 6E, 6F).

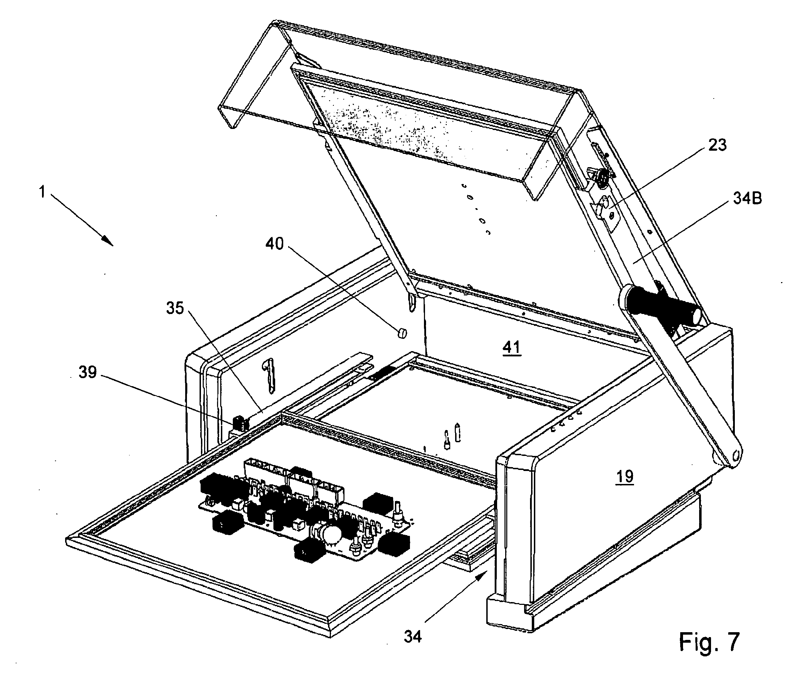

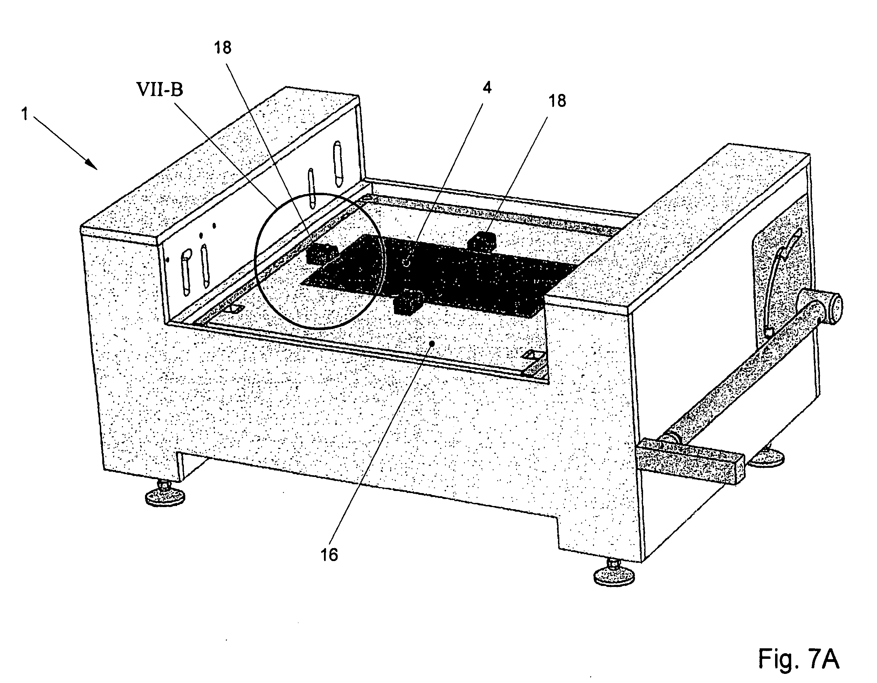

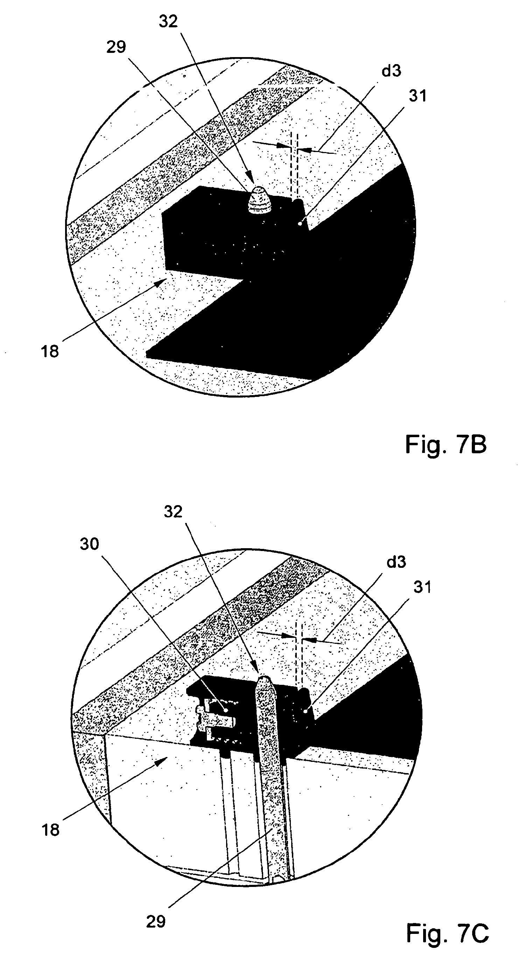

In an embodiment, the probe board holding frame 3, 3B and/or the target PCB holding frame 2 are configured to be manually attached to and/or detached from the test fixture 1 by hands, such that the respective PCB's can be placed in the respective holding frames 2, 3, 3B separate from the test fixture 1. The probe board holding frames 2, 3, 3B can be disconnected from, and reconnected to the test fixture 1 for example by sliding the respective holding frames 2, 3, 3B out and in the holding elements 35, 34, 34B, as illustrated in figure 7.

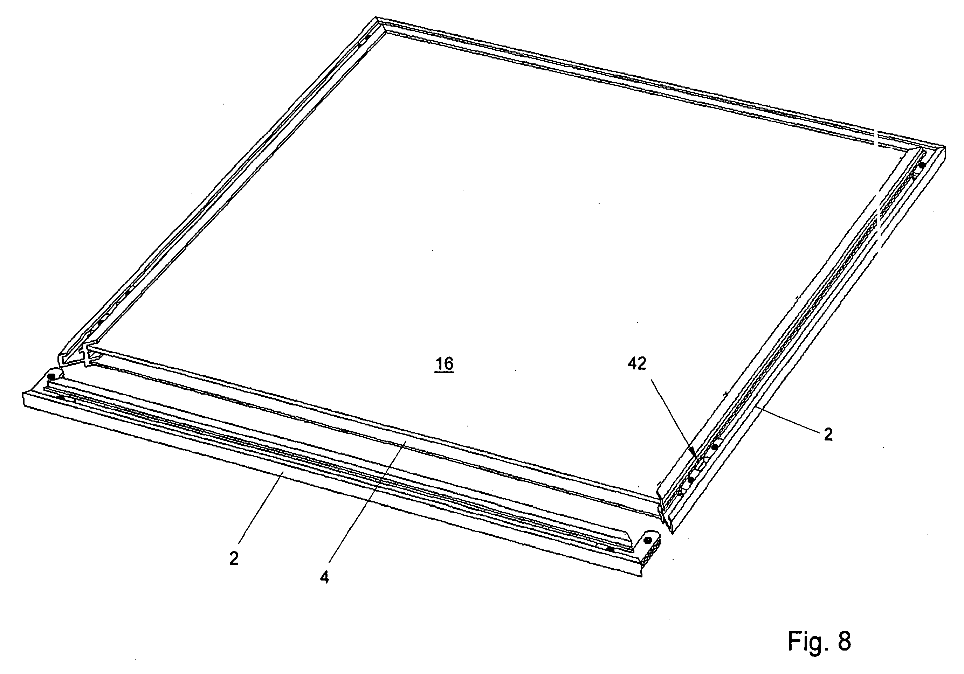

After sliding the target PCB holding frame 2 in to its holding element 35 it can for example be locked into place by a locking finger 39 that is provided in the target board PCB holding frame holding element 35 and a projection 40 that may be provided in the housing 19. The locking finger 39 may be pushed down such that it abuts a notch 42 (see figure 8) that is present in the target PCB holding frame 2 while the target PCB holding frame 2 will abut against the projection 40. In this way, the target PCB holding frame 2 will be held between the locking finger 39 and the projection 40 and will not move.

Preferably, the probe board PCB holding elements 34, 34B are provided with connector points 13B and/or positioning projections 46. The connector points 13B are arranged to be pressed onto into connector plates 13 such that the probes 6 are connected with the connector points 13B, i.e. the user interface circuit 7 and/or such that the probe board PCB 5 fixes into place. The positioning projections 46 are arranged to be pressed onto the positioning holes 10A that are present in the probe board PCB 5 such that the probe board PCB 5, 5A is fixed into place. In an advantageous embodiment, the connector points 13B of the respective first and second holding elements 34, 34 B are pointing up and down, respectively. Consequently, the connector plates 13 of the bottom probe board PCB that is placed in its holding frame 3 should be arranged face down, while the connector plates 13 of the top probe board PCB 5 should be arranged face up.

In figures 4A and 4B an embodiment of the bottom probe board PBC holding element 34 is shown, wherein connector point actuating elements 44 are provided. The actuating elements 44 that may be used to actuate the connector points 13B and/or the positioning projections 46. The elements 44 shown comprise a plate 45 having a cut-away 47 that has a curved shape and a handling element 51. A beam pin 48 extends through the cut-away 47 and is part of a holding element transverse beam 49. The transverse beam 49 supports the connector points 13 and the positioning projections 46. Said transverse beam 49 is connected to side beams 50 such that it hinges around pivot axis A1. The plate 45 is supported by the side beams 50 of the second holding element 34B in a pivoting manner by means of a hinge 52. As can be seen, the cut-away 47 is longitudinally shaped and curved and has a first and second end e1, e2, respectively. In the shown position of the plates 45, the pin 48 abuts against the second end e2, such that the transverse beam 49 is pivoted around its axis A1, such that the connector points 13B and/or the positioning projections 46 are in a position away from the target PCB 4, at least when that target PCB 4 would be positioned into the test fixture 1. When the plate 45 is pushed down, e.g. by pushing the handling element 51 in a direction d3, the pin 48 will move towards the first end point e1 of the cut-away 47 until it abuts against said end point e2. As can be seen, the cut-away 47 is a-centrically curved, i.e. such that the first end point e1 is closer to the axle 52 than the second end point e2. Thus, by pushing the plate 45 in a direction d3 downwards, the pin 47 is moved upward towards the axle 52 such that the connector points 13B and/or the positioning projections 46 are brought upwards, towards the target PCB 4. In this manner a relatively large force is applied to the connector points 13B and/or the positioning projections 46, which is advantageous to establish a reliable connection to the connector plates 13 on the target PCB 4. The connector point actuating elements 44 principle can in general be useful for any sorts of pressing means, e.g. independent of the test fixture 1 and as a separate invention.

As is clear from the position of the projection 40 in figure 7, the target PCB holding frame 2 is kept at a distance from a back wall 41 of the housing. In this way, space is made for pulling the connector points 13B in a direction upwards e.g. when they have to be disconnected from the connecting plates 13.

In figure 7A-C the second probe board holding frame 3B is taken out of the guides 12. The clamping elements 18 are provided on a positioning PCB 16 and clamp a target PCB 4 near the sides. When the handle 20 is operated, preferably when the probe board holding frame 3, 3B approaches the target PCB holding frame 2, more preferably right before the probes 6 touch the target points 11, the clamp abutments 31 close in and clamp the target PCB 4 (fig. 7B) to keep the target PCB 4 in position.

In an embodiment, the clamping elements 18 are provided with resilient means 30 connected to clamp abutments 31, as can be seen in a sectional view in figure 7C. The resilient means 30 hold the clamp abutment 31 in unclamped position, i.e. away from the target PCB 4, such that the target PCB can be placed between the clamp abutments 31. Preferably, a mechanical actuator, e.g. in the form of a locking pin 29, or a positioning pin 10 (fig. 2A), is coupled to the probe board PCB 5 and extends through the clamping elements 18. When the probe board holding frame 3 approaches the target PCB holding frame 2 the locking pin 29 moves through the clamping element 18 and pushes the clamp abutment 31, against the resilient force in the direction of the target PCB 4. It is advantageous when the pin 29 is provided with a rounded nose 32, to actuate the clamp abutment 31. In the embodiment shown in figure 2A, which works according to the same principle as the embodiment of figures 7A-7C, the positioning pin 10 serves as an actuator.

Other actuators for actuating the clamping elements 18 may also be suitable. Advantageously these actuators may be configured to actuate the clamping elements 18 when the probes 6 approach and/or touch the target points 11. The actuators may for example comprise mechanical or electromechanical means.

In principle the clamping elements 18 and/or the actuator explained above are/is, as such, suitable to be applied in any type of known or future test fixture or clamping device. The clamping elements 18, for example in combination with the stiffening profiles, the actuator and/or a target PCB holding frame 4, can be regarded as a separate invention.

The design and construction of the probe board 5 can be realised relatively efficient and cheap. For the design of the target PCB 4 a printed circuit pattern will be designed and drawn, wherein target points 11 are configured on a target PCB 4, or at least in the drawing thereof. Now, by using a PCB for constructing the probe board PCB 5 the pattern used for the target points 11 can be used for configuring probe points on a probe board 5. In principle the probe points, i.e. the locations of the probes 6, are positioned according to the same pattern as the target points 11, since the probes 6 are attached at the probe points on the probe board PCB and the probes 6 need to be contacted with the target points 11. Hence, the design, drawing and construction of the probe board PCB 5 can be done at the same location and by the same person as the design, drawing and construction of the target PCB 4. With the invention, also testing can be readily performed at the same location and/or by the same person.

Furthermore, said printed circuit pattern may be conveniently used for configuring holes 14 in the probe board PCB 5 and/or the second probe board PCB 5B, and/or for configuring holes in the positioning PCB 16.

As described above, it may be advantageous to use a probe board 5, wherein the probes 6 are arranged on a PCB acting as a probe board, so that a target PCB 4 can be tested by contacting its target points 11 to said probes 6 arranged on the PCB, for example by means of the connector plates 13. Consequently, test signals that are received and/or sent by the probes 6 can be processed by a user interface circuit 7 (see fig. 1), e.g. by connecting the probes 6 to an I/O interface 8. In an embodiment, a test fixture 1 as described in the description facilitates the use of such probe board PCB's 5, although other means and/or test fixtures may also be suitable to facilitate the use of probe board PCB's 5.

Furthermore the use of a probe board PCB 5 having a probe board PCB connecting circuit 13A, or at least connector plates 13, readily facilitates the use of intermediate electrical modules, e.g. between the connector plates 13/ probe board PCB connecting circuit 13A and the connector points 13B. For example, the number of test signals and/or target points 11 is not limited by the number of connector points 13B because intermediate splitting elements or other electrical modules can be connected to the connector plates 13/ probe board PCB circuit 13A. This in turn is again facilitated by the easy assembly of a PCB in general, which can in principle be done by any skilled person in the art.

In principle, the positioning PCB's 16 and second probe board PCB's 5B that are used in the test fixture 1 can be applied without surface treatment and/or without copper.

In an embodiment the invention is provided as a kit of parts comprising the test fixture 1, PCB's 4, 5, 16 and/or clamping elements 18. For testing the target PCB 4, the respective PCB's 4, 5, 16 are placed in the test fixture 1 and the clamping elements 18 are placed on the positioning PCB 16. After connecting the probes 6 to a computer, e.g. via an I/O interface 8, the target PCB 4 can be positioned and tested.

Multiple embodiments of the invention comply to norms and standards in the field of PCB and the testing of PCB's, such as European standards IEC/EN 55014, IEC/EN 55022, IEC/EN 60950, IEC 61000-6-1, IEC 61000-6-3, IEC 60335-1, 89/336/EEC, 92/31/EEC, 93/68/EEC 72/23/EEC and/or 93/68/EEC, and/or equivalents thereof.

The invention should not be limited to the words used in this description. For example, in the field, test fixtures 1 may also be referred to as 'bed of nails tester', 'In-Circuit testers' or 'test adapters', while probe boards are sometimes also referred to as 'Bed of nails' or 'connector boards'. PCB's are sometimes referred to as printed wiring boards (PWB) or etched wiring boards. When electric components are connected to the board PCB's are sometimes referred to as printed circuit assemblies (PCA) or printed circuit board assemblies (PCBA). Multi chip modules (MCM) may be regarded as a kind of PCB. The target PCB is sometimes referred to as 'unit under test' (UUT) or 'device under test' (DUT).

It shall be obvious that the invention is not limited in any way to the embodiments that are represented in the description and the drawings. Many variations and combinations are possible within the framework of the invention as outlined by the claims. Combinations of one or more aspects of the embodiments or combinations of different embodiments are possible within the framework of the invention. All comparable variations are understood to fall within the framework of the invention as outlined by the claims.

## Claims

1. Probe board (5) for testing a target PCB (Printed Circuit Board) (4), to be held in a probe board holding frame (3) in a test fixture (1), provided with probes (6) for contacting target points (11) on a target PCB (4), **characterized in that** the probe board (5) comprises at least two probe board PCB's (5A, 5B) extending substantially parallel to each other, wherein the probes (6) are connected to one of the probe board PCB's (5A) and extend through holes (14) in the at least one other probe board PCB (5B).

2. Probe board according to claim 1, wherein said at least two probe board PCB's (5) are positioned at a distance (d) of at least 3 mm from each other, preferably at least 8 mm, more preferably approximately 10 mm.

3. Probe board and target PCB according to one of the preceding claims, wherein a positioning PCB (16) is provided that has holes (17) for the probes (6), wherein in use the holes (17) are in line with the probes (6).

4. Probe board according to one of the preceding claims and a target PCB (4), wherein the target points (11) have approximately the same relative positions as the probes (6) and in use are in line with the probes (6).

5. Probe board according to claim 3 and 4, wherein the target PCB (4) is provided on the positioning PCB (16) which extends approximately parallel the target PCB (4).

6. Test fixture (1) for testing a target PCB (4), comprising a target PCB holding frame (2), a probe board holding frame (3) and guides (12) for guiding at least one of the two frames (2, 3) towards the other frame,
wherein the probe board holding frame (3) is arranged to hold a probe board (5) and to allow connection between probes (6) on the probe board (5) and a user interface circuit (7),
**characterized in that** the probe board comprises at least two PCB's (5A, 5B) extending substantially parallel to each other, such that probes (6) of one of the probe board PCB's (5A) extend through holes (14) in the at least one other probe board PCB (5B), wherein at least one of the at least two PCB's (5A, 5B) is a standard PCB (5A)

7. Test fixture holding frame according to claim 6, wherein at least one probe board holding frame (3) is provided below the target PCB holding frame (2).

8. Test fixture according to claim 6 or 7, wherein a second probe board holding frame (3B) is provided that is configured for holding at least one standard PCB (5C), which is arranged on the opposite side of the target PCB holding frame (2) with respect to the first probe board holding frame (3), so that, in use, both sides of the target PCB (4) can be contacted by the probes (6) on the standard PCB's (5, 5C) held on opposite sides of the target PCB (4).

9. Test fixture according to one of the claims 6 - 8, wherein a moving frame (25) is provided to move both probe board holding frames (34, 34B) along guides (12) in mirrored directions, to and/or from the target PCB holding frame (35).

10. Test fixture according to one of the claims 6 - 9, wherein the probe board holding frame (34, 34B) and/or the target PCB holding frame (35) are configured to be manually attached and/or detached to the test fixture (1), such that the respective PCB's (4, 5, 5C) can be placed in the respective holding frames (35, 34, 34B) separate from the test fixture (1), **characterized in that** the respective probe board holding frame (34, 34B) is arranged to hold at least two PCB's (5A, 5B) substantially parallel to each other, such that probes (6) of one of the probe board PCB's (5A) extend through holes (14) in the at least one other probe board PCB (5B).

11. Test fixture according to one of the claims 6 - 10, wherein the target PCB holding frame (35) and/or the at least one probe board holding frame (34, 34B) are configured to hold PCB's (16, 5A, 5B) near their sides.

12. Test fixture according to one of the claims 6 - 11, wherein clamping elements (18) are provided for clamping a target PCB (4) at least near the sides thereof.

13. Test fixture according to claim 12, wherein a mechanical actuator (10, 29) is provided that is configured to actuate the clamping means (18) when the probes (6) approach and/or touch the target points (11).

14. Test fixture according to claim 12 or 13, wherein in use the clamping elements (18) are fixed to a positioning PCB (16).

15. Test fixture according to one of the claims 6- 14, wherein the target PCB holding frame (2) is configured to hold a positioning PCB (16), wherein the positioning PCB (16) is configured to hold a target PCB (4).

16. Test fixture according to one of the claims 6 - 15, comprising a manual operating mechanism (20) for operating a mechanical moving mechanism for moving the holding frames (2, 3, 3B) along guides (12).

17. Kit of a probe board according to one of the claims 1 - 5 and a test fixture according to one of the claims 6 - 16.

18. The kit of claim 17, further comprising PCB's for use in said test fixture according to one of the claims 6 - 16.

19. Method for making a probe board (5),
wherein a printed circuit pattern (13A) is designed,
wherein said pattern (13A) is used for configuring target points (11) on a target PCB (4),
wherein said pattern (13A) is used for configuring probe points on a probe board (5),
wherein the probe board (5, 5A)) comprises a PCB,
wherein probes (6) are attached at the probe points on the probe board PCB (5, 5A), and wherein the probe board (5) comprises at least two probe board PCB's (5A, 5B) extending substantially parallel to each other within a probe heard holding frame (3), wherein the probes (6) are connected to one of the probe board PCB's (5A) and extend through holes (14) in the at least one other probe board PCB (5B).

20. Method according to claim 19, wherein said probe board PCB (5) and the target PCB (4) are made of approximately the same material.

21. Method according to claim 19 or 20, wherein connector elements (13) are arranged near the side of the probe board PCB (5).

22. Method according to one of the claims 19 - 21, wherein said pattern (13A) is used for configuring holes (17) in a positioning PCB (16).

23. Method for testing a Printed Circuit Board (PCB), wherein probes (6) are arranged on a PCB acting as a probe board (5),
wherein a target PCB (4) is tested by contacting target points (11) on the target PCB (4) with said probes (6) that are arranged on the probe board PCB (5A), wherein the probe board (5) comprises at least two probe board PCB's (5A, 5B) extending substantially parallel to each other within a probe board holding frame (3), wherein the probes (6) are connected to one of the probe board PCB's (5A) and extend through holes (14) in the at least one other probe board PCB (5B).
and wherein test signals that are received and/or sent by the probes (6) are processed by a user interface circuit (7).

24. Method according to claim 23, wherein the probe board PCB (5A) is arranged under the target PCB (4).

25. Method according to claim 23 or 24, wherein the probe board PCB (5A) is provided with connector elements (13) near the sides thereof, via which the probes (6) are connected to the user interface circuit (7).

26. Method according to one of the claims 23 - 24, wherein the probes (6) are at least partly guided through a positioning PCB (16), wherein the positioning PCB (16) is a PCB with holes (17) that are in line with the target points (11) on the target PCB (4).

27. Method according to claim 26, wherein at least one holding frame (2, 3, 3B) is manually attached and/or detached from a test fixture (1).

28. Method according to claims 27, wherein said at least one PCB (5A, 5B, 5C, 16) is placed in the at least one holding frame (2, 3, 3B) separate from the test fixture (1).

29. Method for making a probe board according to one of the claims 19 - 22 after which a method for testing a PCB (4) according to one of the claims 23 - 28 is performed.

## Patentansprüche

1. Sondenkarte (5) zum Testen einer Ziel-PCB (printed circuit board - Leiterplatte) (4), die in einem Sondenkarten-Halterahmen (3) in einer Testvorrichtung (1) gehalten werden soll, mit
Sonden (6) zum Kontaktieren von Zielpunkten (11) auf einer Ziel-PCB (4), **dadurch gekennzeichnet, dass**
die Sondenkarte (5) wenigstens zwei Sondenkarten-PCBs (5A, 5B) umfasst, die sich im Wesentlichen parallel zueinander erstrecken, wobei die Sonden (6) mit einer der beiden Sondenkarten-PCBs (5A) verbunden sind und sich durch Löcher (14) in der wenigstens einen anderen Sondenkarten-PCB (5B) erstrecken.

2. Sondenkarte nach Anspruch 1,
**dadurch gekennzeichnet, dass**
die wenigstens zwei Sondenkarten-PCBs (5) in einem Abstand (d) von wenigstens 3 mm, vorzugsweise 8 mm und besonders bevorzugt von 10 mm von einander beabstandet angeordnet sind.

3. Sondenkarte nach einem der vorhergehenden Ansprüche,
**dadurch gekennzeichnet, dass**
eine Positionierungs-PCB (16) vorgesehen ist, die Löcher (17) für die Sonden (6) aufweist, wobei bei Benutzung die Löcher (17) mit den Sonden (6) in einer Linie liegen.

4. Sondenkarte nach einem der vorhergehenden Ansprüche und Ziel-PCB (4),
**dadurch gekennzeichnet, dass**
die Zielpunkte (11) alle im Wesentlichen dieselbe Relativposition wie die Sonden (6) aufweisen und bei Benutzung mit den Sonden (6) in einer Linie liegen.

5. Sondenkarte nach Anspruch 3 oder 4,
**dadurch gekennzeichnet, dass**
die Ziel-PCB (4) auf der Positionierungs-PCB (16) vorgesehen ist, die sich im Wesentlichen parallel zur Ziel-PCB (4) erstreckt.

6. Testvorrichtung (1) zum Testen einer Ziel-PCB (4), umfassend einen Ziel-PCB-Halterahmen (2), einen Sondenkarten-Halterahmen (3) und Führungen (12), zum Führen von wenigstens einem der zwei Rahmen (2,3) in Richtung des andern Rahmens, wobei
der Sondenkarten-Halterahmen (3) ausgerichtet ist, um eine Sondenkarte (5) zu halten und um eine Verbindung zwischen den Sonden (6) auf der Sondenkarte (5) und einer Benutzer Interface Schaltung (7) zu ermöglichen,
**dadurch gekennzeichnet, dass**
die Sondenkarte wenigstes zwei PCBs (5A,5B) aufweist, die sich im Wesentlichen parallel zueinander erstrecken, so dass sich die Sonden (6) auf einer der Sondenkarten-PCBs (5A) durch Löcher in der wenigstens einen anderen Sondenkarten-PCB (5B) erstrecken, wobei wenigstens eine der wenigstens zwei PCBs (5A,5B) eine Standard-PCB (5A) ist.

7. Testvorrichtungs-Halterahmen nach Anspruch 6,
**dadurch gekennzeichnet, dass**
wenigstens ein Sondenkarten-Halterahmen (3) unter dem Ziel-PCB-Halterahmen (2) angeordnet ist.

8. Testvorrichtung nach Anspruch 6 oder 7,
**dadurch gekennzeichnet, dass**
ein zweiter Sondenkarten-Halterahmen (3B) zum Halten wenigstens einer Standard-PCB (5C) vorgesehen ist, der mit Bezug auf den ersten Sondenkarten-Halterahmen (3) auf der anderen Seite des Ziel-PCB-Halterahmens (2) angeordnet ist, so dass bei Benutzung beide Seiten der Ziel-PCB (4) durch die Sonden (6) der Standard-PCB (4), die auf entgegengesetzten Seiten der Ziel-PCB (4) gehalten sind, kontaktierbar sind.

9. Testvorrichtung nach einem der Ansprüche 6-8,
**dadurch gekennzeichnet, dass**
ein Bewegerahmen (25) vorgesehen ist, um beide Sondenkarten-Halterahmen (34A,34B) entlang Führungen (12) in spiegelbildlichen Richtungen zu dem Ziel-PCB-Halterahmen (35) hinzubewegen und/oder von diesem weg zu bewegen.

10. Testvorrichtung nach einem der Ansprüche 6-9,
wobei der Sondenkarten-Halterahmen (34A,34B) und/oder der Ziel-PCB-Halterahmen (35) ausgebildet sind, um manuell an der Testvorrichtung angebracht und/oder von dieser gelöst zu werden, so dass die entsprechenden PCBs (4,5,5c) in den entsprechenden Halterahmen (35, 34, 34B) getrennt von der Testvorrichtung (1) platziert werden können,
**dadurch gekennzeichnet, dass**
der entsprechende Halterahmen (34,34B) ausgerichtet ist, um wenigstens zwei PCBs (5A,5B) im Wesentlichen parallel zueinander zu halten, so dass sich Sonden (6) einer der Sondenkarten-PCB (5A) durch Löcher (14) in der wenigstens einen anderen Sondenkarten-PCB (5B) erstrecken.

11. Testvorrichtung nach einem der Ansprüche 6-10,
**dadurch gekennzeichnet, dass**
der Ziel-PCB-Halterahmen (35) und/oder der wenigstes eine Sondenkarten-Halterahmen (34,34B) ausgebildet sind, um PCBs (16, 5A, 5B) nahe ihrer Seiten zu halten.

12. Testvorrichtung nach einem der Ansprüche 1-11,
**dadurch gekennzeichnet, dass**
Klemmelemente (16) vorgesehen sind, um eine Ziel-PCB (4) wenigstens nahe ihrer Seiten festzuklemmen.

13. Testvorrichtung nach Anspruch 12,
**dadurch gekennzeichnet, dass**
ein mechanischer Aktuator (10,29) vorgesehen ist, der ausgebildet ist, um die Klemmmittel (18) zu aktivieren, wenn sich die Sonden (6) den Zielpunkten (11) nähern und/oder diese berühren.

14. Testvorrichtung nach Anspruch 12 oder 13,
**dadurch gekennzeichnet, dass**
bei Benutzung die Klemmelemente (18) an einer Positionierungs-PCB (16) befestigt sind.

15. Testvorrichtung nach einem der Ansprüche 6-14,
**dadurch gekennzeichnet, dass**
der Ziel-PCB-Halterahmen (2) ausgebildet ist, um eine Positionierungs-PCB (16) zu halten, wobei die Positionierungs-PCB (16) ausgebildet ist, um eine Ziel-PCB (4) zu halten.

16. Testvorrichtung nach einem der Ansprüche 6-15,
umfassend einen manuellen Betriebsmechanismus (12) zum Betrieb eines mechanischen Bewegemechanismus zur Bewegung der Haltrahmen (2,3,3B) entlang von Führungen (12).

17. Set bestehend aus einer Sondenkarte gemäß einem der Ansprüche 1-5 und einer Testvorrichtung gemäß einem der Ansprüche 6-16.

18. Set nach Anspruch 17, weiter umfassend PCBs zur Verwendung in der genannten Testvorrichtung gemäß einem der Ansprüche 6-16.

19. Verfahren zur Herstellung einer Sondenkarte (5),
wobei ein Leiterplattenmuster (13A) entworfen wird,
wobei das Muster (13A) zur Konfiguration von Testpunkten (11) auf einer Ziel-PCB (4) verwendet wird,
wobei das Muster (13A) zur Konfiguration von Sondenpunkten (11) auf einer Sondenkarte (5) verwendet wird,
wobei die Sondenkarte (5,5A) eine PCB aufweist,
wobei die Sonden (6) an den Sondenpunkten auf der Sondenkarten-PCB (5A,5B) befestigt werden, und wobei die Sondenkarte (5) wenigstens zwei Sondenkarten-PCBs (5A,5B) aufweist, die sich in einem Sondenkarten-Halterahmen (3) im Wesentlichen parallel zueinander erstrecken, wobei die Sonden (6) mit einer der Sondenkarten-PCBs (5A) verbunden werden und sich durch Löcher (14) in der wenigstes einen anderen Sondenkarten-PCB (5B) erstrecken.

20. Verfahren nach Anspruch 19,
**dadurch gekennzeichnet, dass**
die Sondenkarten-PCB (5) and die Ziel-PCB (4) aus einem im Wesentlichen gleichen Material hergestellt werden.

21. Verfahren nach Anspruch 19 oder 20,
**dadurch gekennzeichnet, dass**
Verbindungselemente (13) nahe der Seiten der Sondenkarten-PCB (5) angeordnet werden.

22. Verfahren nach einem der Ansprüche 19-21,
**dadurch gekennzeichnet, dass**
das Muster (13A) verwendet wird, um Löcher (17) in einer Positionierungs-PCB (16) auszubilden.

23. Verfahren zum Testen einer Leiterplatte (PCB), wobei Sonden (6) auf einer als Sondenkarte (5) fungierenden PCB angeordnet werden,
wobei eine Ziel-PCB (4) getestet wird, indem Zielpunkte (11) auf der Ziel-PCB (4) mit den Sonden (6), die auf der Sondenkarten-PCB (5A) angeordnet sind berührt werden, wobei die Sondenkarte (5) wenigstens zwei Sondenkarten-PCBs (5A,5B) aufweist, die sich in einem Sondenkarten-Halterahmen (3) im Wesentlichen parallel zueinander erstrecken, wobei die Sonden (6) mit einer der Sondenkarten-PCBs (5A) verbunden werden und sich durch Löcher (14) in der wenigstens einen anderen Sondenkarten-PCB (5B) erstrecken, und wobei Testsignale, die von den Sonden (6) empfangen und/oder gesendet werden, von einer Benutzer Interface Schaltung (7) verarbeitet werden.

24. Verfahren nach Anspruch 23,
**dadurch gekennzeichnet, dass**
die Sondenkarten-PCB (5A) unter der Ziel-PCB (4) angeordnet wird.

25. Verfahren nach Anspruch 23 oder 24,
**dadurch gekennzeichnet, dass**
die Sondenkarten-PCB (5A) nahe ihrer Seiten mit Verbindungselementen (13) versehen wird, über die die Sonden (6) mit der Benutzer Interface Schaltung (7) verbunden werden.

26. Verfahren nach einem der Ansprüche 23-24,
**dadurch gekennzeichnet, dass**
die Sonden (6) wenigsten teilweise durch die Positionierungs-PCB (16) geführt werden, wobei die Positionierungs-PCB (16) eine PCB mit Löchern (17) ist, die in einer Linie mit den Zielpunkten (11) auf der Ziel-PCB (4) liegen.

27. Verfahren nach Anspruch 26,
**dadurch gekennzeichnet, dass**
wenigstens ein Halterahmen (2,3,3B) manuell an einer Testvorrichtung (1) befestigt und/oder von dieser gelöst wird.

28. Verfahren nach Anspruch 27,
**dadurch gekennzeichnet, dass**
die wenigstes eine PCB (5A,5B,5C,16) getrennt von der Testvorrichtung (1) in dem wenigstens einen Halterahmen (2,3,3B) platziert wird

29. Verfahren zur Herstellung einer Sondenkarte nach einem der Ansprüche 19-22 nach dem ein Verfahren zum Testen einer PCB (4) nach einem der Ansprüche 23-28 durchgeführt wird.

## Revendications

1. Panneau de sonde (5) pour tester une PCB (carte de circuit imprimé) cible (4) destinée à être maintenue dans un bâti de maintien de panneau de sonde (3) dans un élément de test (1), prévu avec des sondes (6) pour mettre en contact des points cibles (11) sur une PCB cible (4), **caractérisé en ce que** le panneau de sonde (5) comprend au moins deux PCB de panneau de sonde (5A, 5B) s'étendant de manière sensiblement parallèle l'une par rapport à l'autre, dans lequel les sondes (6) sont raccordées à l'une des PCB de panneau de sonde (5A) et s'étendent à travers des trous (14) dans au moins une autre PCB de panneau de sonde (5B).

2. Panneau de sonde selon la revendication 1, dans lequel lesdites au moins deux PCB de panneau de sonde (5) sont positionnées à une distance (d) d'au moins 3 mm l'une de l'autre, de préférence au moins 8 mm, encore de préférence approximativement 10 mm.

3. Panneau de sonde et PCB cible selon l'une des revendications précédentes, dans lesquels on prévoit une PCB de positionnement (16) qui a des trous (17) pour les sondes (6), dans lequel, à l'usage, les trous (17) sont alignés avec les sondes (6).

4. Panneau de sonde selon l'une des revendications précédentes et PCB cible (4), dans lesquels les points cibles (11) ont approximativement les mêmes positions relatives que les sondes (6) et, à l'usage, sont alignés avec les sondes (6).

5. Panneau de sonde selon les revendications 3 et 4, dans lequel la PCB cible (4) est prévue sur la PCB de positionnement (16) qui s'étend de manière approximativement parallèle à la PCB cible (4).

6. Elément de test (1) pour tester une PCB cible (4), comprenant un bâti de support de PCB cible (2), un bâti de support de panneau de sonde (3) et des guides (12) pour guider au moins l'un des deux bâtis (2, 3) vers l'autre bâti,
dans lequel le bâti de support de panneau de sonde (3) est agencé pour supporter un panneau de sonde (5) et pour permettre la connexion entre les sondes (6) sur le panneau de sonde (5) et un circuit d'interface utilisateur (7),
**caractérisé en ce que** le panneau de sonde comprend au moins deux PCB (5A, 5B) s'étendant de manière sensiblement parallèle l'une par rapport à l'autre, de sorte que les sondes (6) de l'une des PCB de panneau de sonde (5A) s'étendent à travers des trous (14) dans au moins une autre PCB de panneau de sonde (5B), dans lequel au moins l'une des deux PCB (5A, 5B) est une PCB standard (5A).

7. Bâti de support d'élément de test selon la revendication 6, dans lequel au moins un bâti de support de panneau de sonde (3) est prévu sous le bâti de support de PCB cible (2).

8. Elément de test selon la revendication 6 ou 7, dans lequel on prévoit un second bâti de support de panneau de sonde (3B) qui est configuré pour supporter au moins une PCB standard (5C) qui est agencée sur le côté opposé du bâti de support de PCB cible (2) par rapport au premier bâti de support de panneau de sonde (3), de sorte que, à l'usage, les deux côtés de la PCB cible (4) peuvent être mis en contact par les sondes (6) sur les PCB standard (5, 5C) supportées sur les côtés opposés de la PCB cible (4).

9. Elément de test selon l'une des revendications 6 à 8, dans lequel un bâti de déplacement (25) est prévu pour déplacer les deux bâtis de support de panneau de sonde (34, 34B) le long de guides (12) dans des directions en miroir, vers et/ou depuis le bâti de support de PCB cible (35).

10. Elément de test selon l'une des revendications 6 à 9, dans lequel le bâti de support de panneau de sonde (34, 34B) et/ou le bâti de support de PCB cible (35) sont configurés pour être fixés et/ou détachés manuellement de l'élément de test (1), de sorte que les PCB (4, 5, 5C) respectives peuvent être placées dans les bâtis de support (35, 34, 34B) respectifs séparés de l'élément de test (1), **caractérisé en ce que** le bâti de support de panneau de sonde (34, 34B) respectif est agencé pour supporter au moins deux PCB (5A, 5B) de manière sensiblement parallèle l'une par rapport à l'autre, de sorte que les sondes (6) de l'une des PCB de panneau de sonde (5A) s'étendent à travers des trous (14) dans la au moins une autre PCB de panneau de sonde (5B).

11. Elément de test selon l'une des revendications 6 à 10, dans lequel le bâti de support de PCB cible (35) et/ou le au moins un bâti de support de panneau de sonde (34, 34B) sont configurés pour supporter les PCB (16, 5A, 5B) à proximité de leurs côtés.

12. Elément de test selon l'une des revendications 6 à 11, dans lequel on prévoit des éléments de serrage (18) pour serrer une PCB cible (4) au moins à proximité de ses côtés.

13. Elément de test selon la revendication 12, dans lequel on prévoit un actionneur mécanique (10, 29) qui est configuré pour actionner les moyens de serrage (18) lorsque les sondes (6) se rapprochent et/ou touchent les points cibles (11).

14. Elément de test selon la revendication 12 ou 13, dans lequel, à l'usage, les éléments de serrage (18) sont fixés sur une PCB de positionnement (16).

15. Elément de test selon l'une des revendications 6 à 14, dans lequel le bâti de support de PCB cible (2) est configuré pour supporter une PCB de positionnement (16), dans lequel la PCB de positionnement (16) est configurée pour supporter une PCB cible (4).

16. Elément de test selon l'une des revendications 6 à 15, comprenant un mécanisme de commande manuel (20) pour actionner un mécanisme de déplacement mécanique afin de déplacer les bâtis de support (2, 3, 3B) le long de guides (12).

17. Kit composé d'un panneau de sonde selon l'une quelconque des revendications 1 à 5 et d'au moins un élément de test selon l'une des revendications 6 à 16.

18. Kit selon la revendication 17, comprenant en outre des PCB destinées à être utilisées dans ledit élément de test selon l'une des revendications 6 à 16.

19. Procédé pour fabriquer un panneau de sonde (5),
dans lequel un mode de circuit imprimé (13A) est conçu,
dans lequel ledit modèle (13A) est utilisé pour configurer des points cibles (11) sur une PCB cible (4),
dans lequel le modèle (13A) est utilisé pour configurer des points de sonde sur un panneau de sonde (5),
dans lequel le panneau de sonde (5, 5A) comprend une PCB, dans lequel les sondes (6) sont fixées aux points de sonde sur la PCB de panneau de sonde (5, 5A) et dans lequel le panneau de sonde (5) comprend au moins deux PCB de panneau de sonde (5A, 5B) s'étendant de manière sensiblement parallèle l'une par rapport à l'autre à l'intérieur d'un bâti de support de panneau de sonde (3), dans lequel les sondes (6) sont raccordées à l'une des PCB de panneau de sonde (5A) et s'étendent à travers des trous (14) dans au moins un autre PCB de panneau de sonde (5B).

20. Procédé selon la revendication 19, dans lequel ladite PCB de panneau de sonde (5) et la PCB cible (4) sont réalisées approximativement avec le même matériau.

21. Procédé selon la revendication 19 ou 20, dans lequel des éléments de connecteur (13) sont agencés à proximité du côté de la PCB de panneau de sonde (5).

22. Procédé selon l'une des revendications 19 à 21, dans lequel ledit modèle (13A) est utilisé pour configurer des trous (17) dans une PCB de positionnement (16).

23. Procédé pour tester une carte de circuit imprimé (PCB), dans lequel des sondes (6) sont agencées sur une PCB servant de panneau de sonde (5),
dans lequel une PCB cible (4) est testée en mettant en contact des points cibles (11) sur la PCB cible (4) avec lesdites sondes (6) qui sont agencées sur la PCB de panneau de sonde (5A), dans lequel le panneau de sonde (5) comprend au moins deux PCB de panneau de sonde (5A, 5B) s'étendant de manière sensiblement parallèle l'une par rapport à l'autre à l'intérieur d'un bâti de support de panneau de sonde (3), dans lequel les sondes (6) sont raccordées à l'une des PCB de panneau de sonde (5A) et s'étendent à travers des trous (14) dans au moins l'autre PCB de panneau de sonde (5B),
et dans lequel des signaux de test qui sont reçus et/ou envoyés par les sondes (6) sont traités par un circuit d'interface utilisateur (7).

24. Procédé selon la revendication 23, dans lequel la PCB de panneau de sonde (5A) est agencée sous la PCB cible (4).

25. Procédé selon la revendication 23 ou 24, dans lequel la PCB de panneau de sonde (5A) est prévue avec des éléments de connecteur (13) à proximité de ses côtés, via lesquels, les sondes (6) sont raccordées au circuit d'interface utilisateur (7).

26. Procédé selon l'une des revendications 23 à 24, dans lequel les sondes (6) sont au moins partiellement guidées par une PCB de positionnement (16), dans lequel la PCB de positionnement (16) est une PCB avec des trous (17) qui sont alignés avec les points cibles (11) sur la PCB cible (4).

27. Procédé selon la revendication 26, dans lequel au moins un bâti de support (2, 3, 13) est fixé et/ou détaché manuellement d'un élément de test (1).

28. Procédé selon la revendication 27, dans lequel ladite au moins une PCB (5A, 5B, 5C, 16) est placée dans le au moins un bâti de support (2, 3, 3B) séparé de l'élément de test (1).

29. Procédé pour fabriquer un panneau de sonde selon l'une des revendications 19 à 22, après quoi un procédé pour tester une PCB (4) selon l'une quelconque des revendications 23 à 28 est réalisé.
